(19) Europäisches Patentamt
European Patent Office
Office européen des brevets

(11) EP 1 112 504 B1

(12) EUROPÄISCHE PATENTSCHRIFT

(45) Veröffentlichungstag und Bekanntmachung des Hinweises auf die Patenterteilung:
31.07.2002  Patentblatt 2002/31

(21) Anmeldenummer: 99947299.6

(22) Anmeldetag: 09.09.1999

(51) Int Cl.⁷: G01R 31/02, G01R 27/14, B60R 21/00

(86) Internationale Anmeldenummer:
PCT/EP99/06666

(87) Internationale Veröffentlichungsnummer:
WO 00/14555 (16.03.2000 Gazette 2000/11)

(54) **DIAGNOSESCHALTUNG ZUR WIDERSTANDS- UND LECKSTROMMESSUNG MINDESTENS EINES ELEKTRISCHEN VERBRAUCHERS, INSBESONDERE EINER ZÜNDPILLE EINES KRAFTFAHRZEUG-INSASSENSCHUTZSYSTEMS, UND ENTSPRECHEND AUSGELEGTES INSASSENSCHUTZSYSTEM**

DIAGNOSTIC CIRCUITRY FOR MEASURING THE RESISTANCE AND LEAKAGE CURRENT OF AT LEAST ONE ELECTRIC CONSUMER, ESPECIALLY A PRIMER IN A MOTOR VEHICLE PASSENGER PROTECTION SYSTEM, AND A PASSENGER PROTECTION SYSTEM FITTED THEREWITH

CIRCUIT DE DIAGNOSTIC POUR LA MESURE DE LA RESISTANCE ET DU COURANT DE FUITE D'AU MOINS UN DISPOSITIF CONSOMMATEUR ELECTRIQUE, EN PARTICULIER D'UNE AMORCE D'UN SYSTEME DE PROTECTION DES PASSAGERS D'UN VEHICULE, ET SYSTEME DE PROTECTION EQUIPE DUDIT CIRCUIT

(84) Benannte Vertragsstaaten:
DE FR GB IT

(30) Priorität: 09.09.1998  EP 98117054

(43) Veröffentlichungstag der Anmeldung:
04.07.2001  Patentblatt 2001/27

(73) Patentinhaber: SIEMENS AKTIENGESELLSCHAFT
80333 München (DE)

(72) Erfinder:
• HERMANN, Stefan
D-93096 Köfering (DE)
• SWART, Marten
D-93083 Obertraubling (DE)
• BELAU, Horst
D-84085 Langquaid (DE)

(56) Entgegenhaltungen:
EP-A- 0 701 928          DE-C- 19 638 393
US-A- 5 506 509          US-A- 5 640 095
US-A- 5 666 065          US-A- 5 805 058

**Beschreibung**

Die Erfindung betrifft eine Diagnoseschaltung zur Widerstands- und Leckstrommessung mindestens eines elektrischen Verbrauchers, speziell einer Zündpille eines Kraftfahrzeug-Rückhaltesystems. Bei solchen elektrischen Verbrauchern in Form von Zündpillen besteht häufig die Anforderung, den Widerstand und den Leckstrom zu Diagnosezwecken zu messen, um die korrekte Funktionsfähigkeit der Zündpille sicherzustellen. Diese Diagnose kann in regelmäßigen oder unregelmäßigen Intervallen, beispielsweise beim Starten des Kraftfahrzeugs, ausgeführt werden. Wenn bei der Diagnose festgestellt werden sollte, daß der Zündpillenwiderstand außerhalb des zulässigen Toleranzbereichs liegt und/oder ein unzulässiger Leckstrom auftritt, kann rechtzeitig eine Fehlermeldung abgegeben und/oder es können die Ansteuerungsparameter (Treiberspannung, Treiberstrom, Ansteuerungszeit) zur Ansteuerung der Zündpille im Bedarfsfall angepaßt werden.

Bei der Diagnosemessung werden üblicherweise der Zündpillenwiderstand und der Zündpillenleckstrom nacheinander gemessen. Wenn jedoch eine Vielzahl von Zündpillen vorgesehen ist, was bei modernen Kraftfahrzeug-Rückhaltesystemen häufig der Fall ist, wird für die Prüfung aller Zündpillen eine lange Zeitdauer benötigt.

Aus der DE 196 38 393 C1 ist eine Diagnoseschaltung gemäß dem Oberbegriff des Patentanspruchs 1 bekannt, bei der die zu testende Zündpille von einer breitbandig angesteuerten Stromquelle gespeist wird und die hierbei an der Zündpille abfallende Spannung über ein Schaltglied an einen ebenfalls breitbandig gespeisten Korrelator angelegt wird. Zur Leckmessung können weitere getrennte Stromquellen zur Messung von Leckströmen gegen Masse oder Batteriespannung vorgesehen sein.

In der US 5 640 095 ist eine Schaltung zum Testen des Leckwiderstands eines Schaltungspunkts beschrieben, bei der ein Teststrom in den Schaltungspunkt eingespeist und die hierbei am Schaltungspunkt auftretende Spannung erfaßt wird. Zur bipolaren Leckwiderstandsmessung können zwei entgegengesetzt gerichtete Meßströme in den Schaltungspunkt eingespeist werden.

EP-A 0 486 114 offenbart ein Gerät zum Testen einer elektrischen Schaltung hinsichtlich Leckstrom und Durchgang, wobei die Schaltung Teil einer Brückenschaltung ist, deren Zweige mit identischen Strömen gespeist werden. Zur Leckstromerfassung wird die Brückenspannung ausgewertet.

Der Erfindung liegt die Aufgabe zugrunde, eine Diagnoseschaltung zu schaffen, die eine rasch durchführbare präzise Diagnose ermöglicht.

Diese Aufgabe wird mit den im Patentanspruch 1 genannten Merkmalen gelöst.

Weiterhin wird mit der Erfindung ein Kraftfahrzeug-Insassenschutzsytem gemäß Anspruch 9 oder 10 geschaffen.

Vorteilhafte Ausgestaltungen der Erfindung sind in den Unteransprüchen angegeben.

Bei der erfindungsgemäßen Diagnoseschaltung werden der elektrische Widerstand des mindestens einen Verbrauchers, insbesondere der Zündpille, und der Leckstrom durch vorzugsweise mindestens teilweise separat aufgebaute Erfassungsschaltungen gemessen. Diese Messungen können gleichzeitig ausgeführt werden. Damit ist das insgesamt zur Widerstands- und Leckstrommessung benötigte Zeitintervall recht kurz. Insbesondere wenn eine Vielzahl von zu überprüfenden Verbrauchern, beispielsweise mehr als 10 Zündpillen-Zündkreise, vorhanden sind, läßt sich das insgesamt benötigte Diagnosezeitintervall drastisch verkürzen. Bei einer gleichzeitigen Leckstrombestimmung kann zudem das auf einer Strommessung beruhende Widerstandsmeßergebnis sofort unter Berücksichtigung des Leckstroms korrigiert werden, so daß die Meßgenauigkeit erhöht ist.

Die Leckstrommessung kann in einfacher Weise durch Differenzbildung zwischen dem eingangsseitig eingespeisten und ausgangsseitig gemessenen Strom ermittelt werden. Dieser Differenzstrom wird vorzugsweise über einen Widerstandsspannungsteiler erfaßt, der an seinem Abgriff eine den Leckstrom repräsentierende Spannung generiert. Hierbei sind zwei miteinander verbundene Strombänke vorgesehen, die den in die Zündpille eingespeisten bzw. aus der Zündpille ausfließenden Strom nachbilden. Ein Verbindungspunkt zwischen diesen Strombänken kann mit der Leckstrommeßschaltung, vorzugsweise dem Widerstandsspannungsteiler, verbunden sein. Durch den Widerstandsspannungsteiler wird erreicht, daß die am Verbindungspunkt auftretende Meßspannung zwischen den an den Widerstandsspannungsteiler angelegten Referenzspannungen liegt und sich je nach Leckstromrichtung erhöht oder verringert. Anstelle eines Widerstandsspannungsteilers kann aber auch ein einzelner, beispielsweise gegen Masse geschalteter Widerstand vorgesehen sein. In diesem Fall wechselt die Leckstrommeßspannung je nach Leckstromrichtung ihre Polarität.

Vorzugsweise ist mit einer der Strombänke ein Spannungsregler verbunden, der die an einem Verbraucheranschluß auftretende Spannung auf einen bestimmten Wert regelt. Damit sind die Strom- und Spannungsverhältnisse am Verbraucher fest vorgegeben und es wird die mit diesem Anschluß verbundene Strombank im Unterschied zu der an den anderen Verbraucheranschluß angeschlossenen Strombank durch aufgeprägte Spannung und nicht durch eingeprägten Strom gesteuert. In bevorzugter Ausgestaltung ist die Spannung variabel, so daß z.B. Leckstrommessungen mit unterschiedlichen Potentialwerten wiederholbar sind. Damit können auch Leckwiderstände (Ableitwiderstände) gegen zwischen Masse und Versorgungsspannung liegende Potentialwerte zuverlässig detektiert werden.

Die Diagnoseschaltung kommt vorzugsweise bei Kraftfahrzeug-Insassenschutzsystemen, insbesondere Airbagsystemen, zum Einsatz und kann direkt in das Rückhaltesystem-Steuergerät integriert werden. Dies erlaubt eine rasche Diagnose mit kurzen Einschwingzeiten.

Vorzugsweise ist eine Strombank (Stromspiegelschaltung) vorgesehen, die den bei der Diagnose durch die Zündpille fließenden, vorzugsweise über eine Stromquelle eingeprägten Strom identisch oder mit festen Proportionalitätsbeziehungen nachbildet und über separate Anschlüsse zur Widerstandsmeßschaltung und Leckstrommeßschaltung leitet. Dies erlaubt eine Strommessung ohne Beeinflussung und Verfälschung des tatsächlich durch die Zündpille fließenden Stroms. Auch gegenseitige unerwünschte Beeinflussungen bei der Widerstands- und Leckstrommessung lassen sich durch die separaten Strombankanschlüsse verhindern. Bevorzugt ist hierbei eine Ausgestaltung, bei der die zu der Widerstandsmeßschaltung und der Leckstrommeßschaltung gespeisten Ströme nur einem Bruchteil, beispielsweise einem Zehntel des zur Zündpille gespeisten Stroms entsprechen. Damit läßt sich einerseits eine zur zuverlässigen Diagnose ausreichende Stromspeisung der Zündpille sicherstellen und andererseits erreichen, daß bei der Auswertung nur kleine Ströme verkraftet werden müssen. Diese geringen Ströme gewährleisten zudem, daß die Leistungsaufnahme gering ist und keine starke thermische Belastung der Auswerteschaltung auftritt. Ferner müssen auch nur geringe Ströme aufgebaut und geschaltet werden. Insbesondere bei Einsatz eines vorzugsweise analog aufgebauten Multiplexers und damit einer zeitselektiven Messung einer Mehrzahl von Zündpillen ergibt sich stark verringerter Stromverbrauch.

Die Zündpillenwiderstandsmessung erfolgt vorzugsweise durch getrennte Messung des durch die Zündpille fließenden, vorzugsweise über die Strombank nachgebildeten Stroms und der an der Zündpille hierbei abfallenden Spannung.

Vorteilhaft werden unterschiedliche Ströme für die Widerstands- und Leckstrommessung generiert. Der Leckstrom wird vorzugsweise nur mit der geringeren Stromstärke gemessen, da sich dann unerwünschte Stromverluste besonders deutlich zeigen.

Vorzugsweise ist ein Multiplexer zur Umschaltung zwischen verschiedenen Verbrauchern vorhanden. Die Widerstands- und Leckstromerfassungskomponenten müssen demzufolge jeweils nur einfach vorgesehen werden, was nicht nur den Schaltungsaufwand verringert, sondern auch gleiche Meßbedingungen, Empfindlichkeit, Meßtoleranzen usw. gewährleistet und eine beliebige Erweiterbarkeit bietet. Auch die Kalibrierung muß nur einfach erfolgen.

Eine exakte Widerstandsmessung mit Leckstrom- und/oder Offsetkompensation läßt sich durch zweifache Meßwiederholung mit unterschiedlichen Stromstärken und Differenzbildung der Meßergebnisse erreichen.

Damit kann eine Vielzahl von Verbrauchern, insbesondere Zündpillen, mittels der gleichen Widerstands- und Leckstrommeßschaltungskomponenten gemessen werden. Der Multiplexer ist insbesondere als analoger Multiplexer ausgelegt und weist mit den einzelnen Zündpillen in Reihe geschaltete Schalter auf, so daß die Zündpillen sukzessive einzeln getestet werden können. Die an den Zündpillen abfallenden Spannungen werden vorzugsweise über einen Spannungsdetektor, z.B. einen Operationsverstärker gemessen. Vorzugsweise ist auch dieser Operationsverstärker über Schalter des Multiplexers mit den Anschlüssen aller zu untersuchenden Verbraucher verbunden. Dies begründet zwar einen etwas höheren Schalteraufwand als eine ebenfalls mögliche, dann ohne zusätzliche Schalter zu realisierende direkte Verbindung des Operationsverstärkers mit den Strombankanschlüssen der mit den Verbrauchern in Reihe geschalteten Multiplexer-Schalter. Jedoch ist es bei dieser Verschaltung nun möglich, unmittelbar die Verbraucherspannung ohne irgendwelche Verfälschungen durch Spannungsabfälle an den mit den Verbrauchern in Reihe geschalteten Multiplexerschaltern exakt zu messen. Vorzugsweise sind zusätzliche Dioden zwischen dem Operationsverstärker und den Verbrauchern vorgesehen, durch die unerwünschte Beeinflussungen durch Rückströme oder dergleichen verhindert werden.

Vorzugsweise ist, sofern vorhanden, der Spannungsregler direkt mit einem Anschluß des Spannungsdetektors und folglich über den gerade geschlossenen Multiplexerschalter an den einen Anschluß der gerade gemessenen Zündpille angeschlossen, so daß das dort auftretende Potential geregelt wird.

Die Erfindung eignet sich für alle elektrischen Verbraucher, bei denen der Widerstand (Impedanz) und der Leckstrom gemessen werden sollen, ist insbesondere aber für die Zündpillendiagnose einer Mehrzahl von Zündpillen-Zündkreisen geeignet und ausgelegt, da sich hier eine sehr schnelle Diagnosemessung mit kurzen Einschwingzeiten und gleichzeitiger Meßbarkeit von Leckströmen und Zündpillenwiderständen erreichen läßt sowie ein einfach aufgebauter und steuerbarer analoger Multiplexer verwenden läßt. Die schaltungs- und steuerungstechnischen Anforderungen an den analogen Multiplexer sind sehr gering, da nur eine kleine Anzahl von Schaltern je Zündpille (vier Schalter je Zündpille) benötigt werden. Die übrigen Schaltungskomponenten lassen sich gemeinsam zur Durchführung aller Diagnosemessungen einsetzen und müssen somit nur einfach vorgesehen werden. Die Erfindung läßt sich auch in Form einer integrierten Schaltung ausbilden und benötigt in diesem Fall nur geringe Siliziumfläche.

Mit der Erfindung wird ferner ein vorzugsweise mit einer solchen Diagnoseschaltung ausgestattetes Kraftfahrzeug-Insassenschutzsystem geschaffen, das sich durch hohe Betriebssicherheit bei Aufteilung der Zündtransistorpaare auf unterschiedliche Chips auszeichnet und/oder eine Zündung von Zündpillen mit verringerter Anzahl von Zündtransistoren und Leitungen ermöglicht, wobei die selektive Testbarkeit jedoch erhalten bleibt.

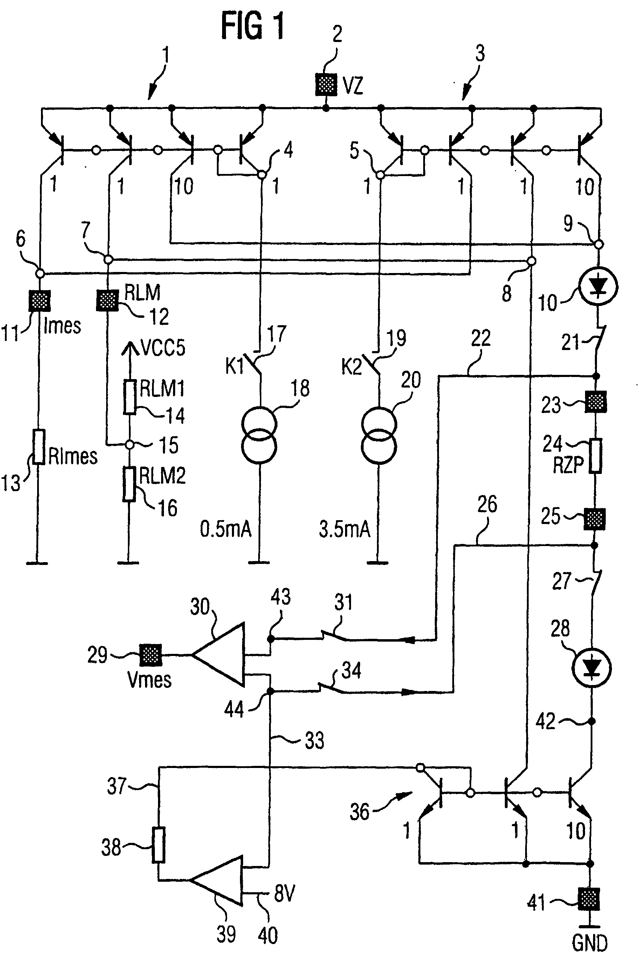

Die Erfindung wird nachstehend anhand von Ausführungsbeispielen unter Bezugnahme auf die in den Fign. 1 bis 5 dargestellten Blockschaltbildern näher beschrieben.

Die in Fig. 1 dargestellte Diagnoseschaltung enthält eine Strombank (Stromspiegelschaltung) 1, die aus mehreren (hier: vier) Transistoren besteht, die so verschaltet sind, daß sie jeweils identische oder proportional gleiche Ströme führen. Die bei den einzelnen Transistoren angegebenen Zahlenwerte "1" bzw. "10" bezeichnen die Stromverstärkungsfaktoren, so daß in den mit "1" bezeichneten Transistoren jeweils gleich große Ströme fließen, während durch den mit "10" bezeichneten Transistor der zehnfache Strom fließt. Alle Emitteranschlüsse der Transistoren der Strombank 1 sind gemeinsam an einen Versorgungsspannunasanschluß 2 angeschlossen, an dem eine Versorgungsspannung VZ anliegt. Die Steueranschlüsse aller Transistoren der Strombank 1 sind intern miteinander sowie mit einem Anschluß 4 verbunden, der über einen Schalter 17 an eine Stromquelle 18 angeschlossen ist. Die Stromquelle 18 dient insbesondere zur Leckstrommessung und erzeugt einen geringen Strom von beispielsweise 0,5 mA.

Die weiteren Ausgänge (Kollektoren) der Transistoren der Strombank 1 sind jeweils unabhängig voneinander mit Anschlüssen 6, 7 bzw. 9 verbunden.

Eine zweite Strombank (Stromspiegelschaltung) 3 ist in ähnlicher Weise wie die Strombank 1 aufgebaut und über ihre jeweiligen, zusammengefaßten Emitteranschlüsse mit dem Versorgungsspannungsanschluß 2 verbunden, wohingegen die Steueranschlüsse der Transistoren der Strombank 3 jeweils gemeinsam sowie mit einem Ausgangsanschluß 5 verbunden sind, der über einen Schalter 19 mit einer Stromquelle 20 verbindbar ist. Die Stromquelle 20 erzeugt einen höheren Strom als die Stromquelle 18, beispielsweise 3,5 mA. Die anderen Ausgangsanschlüsse der Transistoren der Strombank 3 sind separat an die Anschlüsse 6, 7 bzw. 9 angeschlossen und damit paarweise mit den Anschlüssen der Strombank 1 verbunden. Hierbei weisen die beiden mit dem Anschluß 9 verbundenen Transistoren der Strombänke 1 und 3 jeweils den Verstärkungsfaktor "10" auf, während alle anderen Transistoren den Verstärkungsfaktor "1" besitzen.

Der zu messende Verbraucher ist eine Zündpille 24, die Teil einer zwischen den Anschluß 9 und einen Masseanschluß 41 geschalteten Reihenschaltung bildet. Die Reihenschaltung enthält in dieser Reihenfolge eine in Durchlaßrichtung geschaltete Diode 10, einen Schalter 21, die zwischen Anschlüsse (für die Kontaktierung und die Messung) 23 und 25 geschaltete Zündpille 24, einen Schalter 27, eine in Durchlaßrichtung gepolte Diode 28 und einen Transistor einer weiteren Strombank 36.

Mit dem Anschluß 6 ist ein als Meßanschluß dienender Anschluß 11 verbunden, zwischen den und Masse ein Meßwiderstand 13 mit definiertem Widerstandswert geschaltet ist. Mit dem Anschluß 7 ist ebenfalls ein als Meßanschluß dienender Anschluß 12 verbunden, der an einen Abgriff 15 eines Widerstände 14 und 16 enthaltenden Widerstands-Spannungsteilers angeschlossen ist. Die in Reihe geschalteten Widerstände 14 und 16 sind zwischen zwei Referenzpotentiale geschaltet, nämlich einerseits eine Referenzspannung VCC5 (z.B. 5 V)und andererseits Masse. Der Anschluß 7 ist ferner mit einem Anschluß 8 verbunden, der einerseits mit einem Anschluß (Kollektor) eines Transistors der Strombank 36 und andererseits mit einem Ausgang eines Transistors der Strombänke 1 und 3 verbunden ist. Die Emitter der drei Transistoren der Strombank 36 sind gemeinsam an den Masseanschluß 41 angeschlossen, wohingegen ihre Steueranschlüsse miteinander und mit einer Leitung 37 verbunden sind. Der mit der Zündpille 24 verbundene Transistor der Strombank 36 besitzt den Verstärkungsfaktor 10, wohingegen die anderen Transistoren der Strombank 36 den Verstärkungsfaktor 1 zeigen, d.h. nur ein Zehntel des Stromwerts des mit der Zündpille 24 verbundenen Transistors der Strombank 36 führen.

Zur Messung der an der Zündpille 24 abfallenden Spannung sind die Anschlüsse 23 und 25 über Leitungen 22 bzw. 26, und Schalter 31 bzw. 34 an einen Spannungsdetektor in Form eines Operationsverstärkers 30 angeschlossen. Der Operationsverstärker 30 arbeitet als Differenzverstärker, der die an seinen Eingangsanschlüssen 43, 44 anliegende Spannungsdifferenz in eine entsprechende Ausgangsspannung umsetzt, die an einem Spannungsmeßanschluß 29 abgegeben wird.

Zur Spannungsregelung der an dem Eingangsanschluß 42 der Strombank 36 und damit am Anschluß 25 auftretenden Spannung ist ein Operationsverstärker 39 vorhanden, an dessen Eingang 40 eine dem gewünschten Spannungswert entsprechende Referenzspannung, beispielsweise 8 V, angelegt ist und der über einen Ausgangswiderstand 38 und die Leitung 37 den in der Strombank 36 fließenden Strom steuert. Der andere Eingang des Operationsverstärkers 39 ist über eine Leitung 33 mit einem Eingang des Operationsverstärkers 30 und dem Schalter 34, und damit mit dem Anschluß 25, verbunden.

Die Schalter 21, 27, 31 und 34 stellen einen Teil eines analogen Multiplexers dar, der über weitere gleichartige Schalter verfügt, über die die in der Zeichnung dargestellten Schaltungskomponenten (mit Ausnahme der Komponenten 22 bis 27, 31, 34) mit weiteren Zündpillen für deren Test sukzessive verbindbar sind.

Im folgenden wird die Funktionsweise der Schaltung erläutert. Zur Leckstrom- und/oder Widerstandsbestimmung der Zündpille 24 wird zunächst der Schalter K1 geschlossen, so daß in dem mit dem Anschluß 4 verbundenen Transistor der Strombank 1 ein entsprechender Strom, von beispielsweise 0,5 mA, eingeprägt wird. Dies führt dazu, daß in dem mit dem Anschluß 9 verbundenen Transistor der Strombank 1 ein zehnfach höherer Strom (bei diesem Beispiel 5 mA) fließt, der in die Zündpille 24 über die geschlossenen Schalter 21 und 27 eingespeist wird.

Dieser Strom fließt dann weiter durch den rechts dargestellten Transistor der Strombank 36, die über den Spannungsregler 39 so gesteuert wird, daß die Spannung am Anschluß 25 den gewünschten Wert besitzt. Dieser Stromfluß führt zu einem entsprechenden Spannungsabfall an der Zündpille 24, der über die Leitungen 22 und 26 sowie die geschlossenen Schalter 31 und 34 an den Differenzverstärker 30 angelegt wird und zu einer entsprechenden Meßspannung am Anschluß 29 führt. Hierdurch wird die an der Zündpille 24 abfallende Spannung detektiert. Über den Anschluß 6 fließt gleichzeitig ein zum Zündpillenstrom proportionaler (zehnfach niedriger) Strom in den Meßwiderstand 13, wobei die am Anschluß 11 auftretende Spannung gemessen wird. Dieser Spannungswert ist direkt proportional zum Zündpillenstrom und repräsentiert somit diesen (Spannung U am Anschluß 11 = (Widerstandswert des Widerstands 13) x ($I_{Zündpille}$/10)). Aus der am Anschluß 29 abgegebenen, an der Zündpille abfallenden Spannung und dem über die Spannung am Anschluß 11 ermittelbaren Zündpillenstrom läßt sich der Zündpillenwiderstand gemäß der Gleichung R = U/I durch eine nicht gezeigte, mit den Anschlüssen 11 und 29 verbundenen Auswerteschaltung ermitteln.

Gleichzeitig mit der Widerstandsbestimmung kann über den Spannungsteiler 14 bis 16 der Zündpillen-Leckstrom über die am Anschluß 12 auftretende Spannung erfaßt werden. Sofern kein Leckstrom vorhanden ist, ist der über den Anschluß 9 zur Zündpille 24 gespeiste Strom gleich groß wie der durch den rechten Transistor der Strombank 36 fließende Strom. Der von der Strombank 3 und/oder 1 zum Anschluß 8 gespeiste Strom wird dann von dem mit diesem Anschluß 8 verbundenen Transistor der Strombank 36 vollständig aufgenommen, so daß in den Spannungsteiler 14 bis 16 Strom weder eingespeist noch aus diesem abgezogen wird. Die Spannung am Anschluß 15 entspricht daher dem durch die Potentiale VCC5 und Masse bestimmten, durch das Widerstandsverhältnis festgelegten Potentialwert. Wenn jedoch ein Leckstrom auftritt, wird je nach dem, ob der Leckstrom gegen Pluspotential oder Masse fließt, eine Asymmetrie des in die Zündpille eingespeisten und aus dieser ausfließenden Stroms auftreten, so daß in den Spannungsteiler 14 bis 16 Strom eingeleitet oder aus diesem abgezogen wird. Dies führt zu einer entsprechenden Potentialverschiebung am Abgriff 15 nach oben oder unten, so daß die am Anschluß 12 durch die nicht dargestellte Auswerteschaltung gemessene Spannung entsprechend variiert. Der Leckstrom ist hierbei direkt proportional zu der am Anschluß 12 auftretenden Spannungsverschiebung gemäß der Gleichung: Leckstrom = $10\Delta U_{12}$/(Widerstandswert der Parallelschaltung aus den Widerständen 14 und 16). Hierbei bezeichnet $\Delta U12$ die am Anschluß 12 erfaßte Spannungsabweichung gegenüber der bei leckstromfreiem Zustand auftretenden Spannung.

Aufgrund der kleinen Größe des Leckstroms in der Regel von nur 1 bis 2 mA wird vorzugsweise zur Leckstrommessung nur der Schalter K1 geschlossen, der Schalter K2 aber geöffnet, so daß Strom nur durch die Stromquelle 18 in die Strombank 1 eingespeist wird, die Strombank 3 aber nicht aktiv ist. Hierdurch wird die Zündpille 24 nur von einem Strom durchflossen, der deutlich geringer ist als derjenige bei aktiver Stromquelle 20 (beim dargestellten Beispiel nur etwa 5 mA), so daß eventuelle Leckstromverluste sich entsprechend stärker anteilig auswirken und folglich besser detektierbar sind.

Zur Stromerhöhung bei der Widerstandsmessung kann anschließend die Stromquelle 20 durch Schließen des Schalters 19 eingeschaltet werden, so daß nun ein Strom von 3,5 mA fließt. Falls der Schalter 17 geschlossen gehalten bleiben sollte, wird durch die beiden Stromquellen 18 und 20 insgesamt ein Strom von 4 mA generiert wird, der über die Strombänke 1 und 3 in einen Zündpillenstrom von etwa 40 mA umgesetzt wird. Der Zündpillenwiderstand läßt sich in identischer Weise wie vorstehend erläutert messen, zum Beispiel gemäß der Gleichung

$$R_{Zündpille} = (U_{Zündpille} \text{ (am Anschluß 29)} / (U_{Anschluß\ 11} \times 10)) \times R_{Wi\ derstand\ 13.}$$

Zur weiteren Erhöhung der Meßgenauigkeit bei der Widerstandsmessung läßt sich der bei der Leckstrommessung (nur Schalter 17 geschlossen) erhaltene Zustand bei der Widerstandsmessung als zweiter Meßwert berücksichtigen. In diesem Fall kann die Berechnung gemäß der nachstehend angegebenen Gleichung ausgeführt werden:

$$R_{Zündpille} = 1/10 \times (U_{Zündpille2}/U_{2(Anschluß\ 11)} - U_{Zündpille1}/U_{1(Anschluß\ 11)})$$

$$\times R_{13}$$

Hierbei bezeichnet $R_{Zündpille}$ den Zündpillenwiderstand, $U_{Zündpille2}$ den an der Zündpille 24 bei geschlossenem Schalter 17 und 19 auftretenden Spannungswert; $U_2$ (Anschluß in den am Anschluß 11 bei geschlossenem Schalter 17 und 19 auftretenden Spannungswert: $U_{Zündpille\ 1}$ den an der Zündpille 24 bei geschlossenem Schalter 17, aber offenem Schalter 19 auftretenden Spannungswert; $U_{1\ (Anschluß\ 11)}$ den am Anschluß 11 bei geschlossenem Schalter 17, aber offenem Schalter 19 auftretenden Spannungswert. Durch diese Differenzbildung läßt sich der Einfluß des Leckstroms auf die Zündpillenwiderstandsermittlung kompensieren und somit eine sehr genaue Messung erreichen. Diese Meßmethode ermöglicht zugleich auch eine Offsetkompensation. Mit der Erfindung wird folglich auch ein entsprechendes Meßverfahren mit zweifacher, aufeinanderfolgender Messung mit unterschiedlicher Erregung und Differenzbildung von erhaltenen und/oder zwischenberechneten Meßwerten bereitgestellt.

Anstelle des Widerstandsspannungsteilers 14 bis 16 ist es auch möglich, beispielsweise nur den Widerstand 16 vorzusehen, den Widerstand 14 und dessen Anschluß an eine Referenzspannungsquelle jedoch entfallen zu lassen. Des weiteren ist es möglich, die Stromquelle 18 oder 20 samt zugehörigem Schalter und zugehöriger Strombank zur Schaltungsvereinfachung wegzulassen. Ferner können anstelle der Strombänke 1, 3 und 36 auch Stromspiegelschaltungen verwendet werder, die in allen Zweigen identische Ströme führen, oder interne Proportionalitätsfaktoren aufweisen, die sich von den vorliegend vorgesehenen Werten 10:1 unterscheiden.

Zusammenfassend bilden der Meßwiderstand 13 und der Operationsverstärker 30 samt jeweils zugehöriger Beschaltung einen Bestandteil der Widerstandsmeßschaltung (gemeinsam mit der nicht dargestellten, mit den Anschlüssen 11, 12 und 29 verbundenen Auswerteschaltung), wohingegen der Spannungsteiler 14 bis 16 einen Teil der Leckstrommeßschaltung (zusammen mit der nicht dargestellten Auswerteschaltung) bildet.

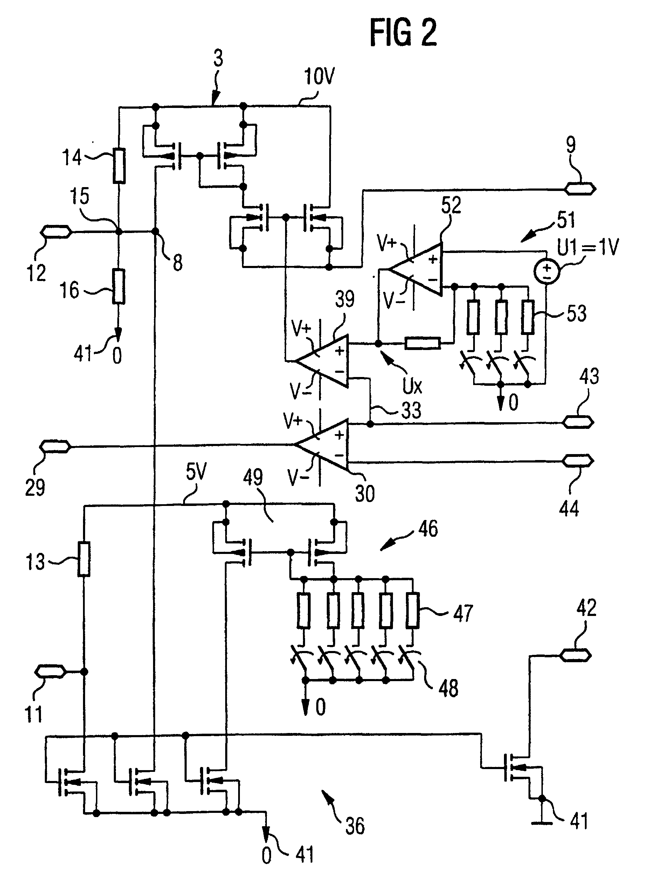

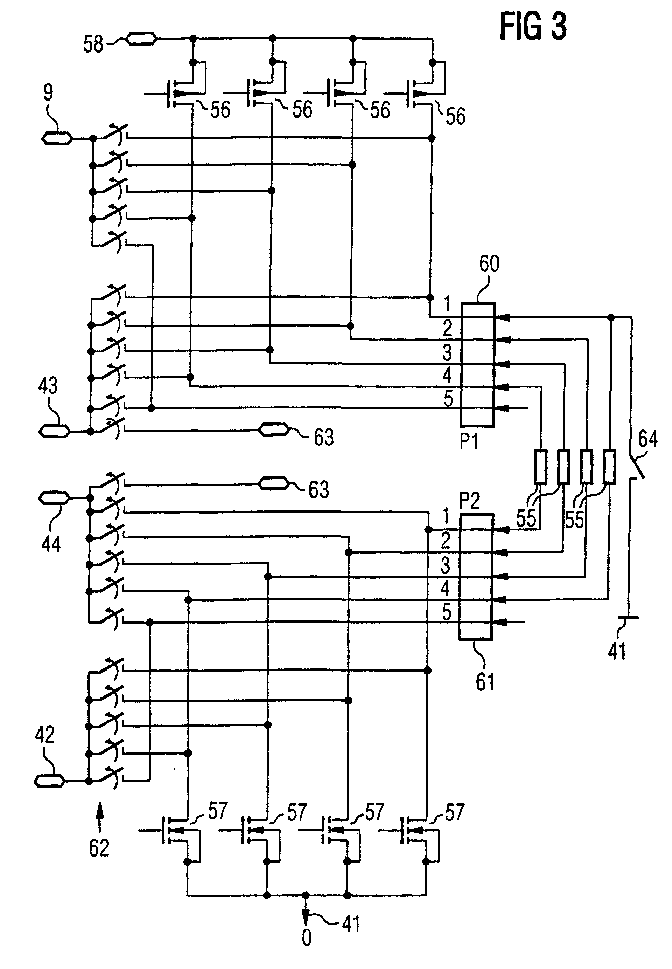

In den Fign. 2 und 3 ist ein weiteres Ausführungsbeispiel der elektrischen Komponenten eines erfindungsgemäß ausgestalteten Kraftfahrzeug-Insassenschutzsystems gezeigt, das eine zentrale Diagnoseschaltung zur Messung einer Mehrzahl von elektrischen Verbrauchern, insbesondere von Zündpillen und/oder Schaltern oder sonstigen hinsichtlich ihres Widerstands und/oder Leckstroms zu überwachenden Komponenten gezeigt. Diejenigen Komponenten, die mit den in Fig. 1 gezeigten Komponenten identisch sind und/oder gleiche Funktion ausüben, sind mit denselben Bezugszeichen wie in Fig. 1 bezeichnet. Bezüglich dieser Komponenten wird auf die vorstehenden Erläuterungen verwiesen. Die Fign. 2 und 3 sind so zusammenzusetzen, daß die Anschlüsse 9 und 42 bis 44 jeweils miteinander verbunden sind, so daß sich Fig. 3 rechts von Fig. 2 anschließt. Fig. 2 zeigt den Diagnoseschaltungsabschnitt, während in Fig. 3 der Multiplexerabschnitt einschließlich der zu messenenden Verbraucher und Treibertransistoren gezeigt ist.

Bei der in Fig. 2 gezeigten Schaltung ist anders als beim Ausführungsbeispiel gemäß Fig. 1 nur eine einzige Strombank 3 auf der Hochpegelseite (z.B. Spannung von 10 V ) vorhanden. Weiterhin sind die beiden Stromquellen 18 und 20 durch eine steuerbare Stromquellenschaltung 46 ersetzt, die auf der Niederpegeiseite (zwischen z.B. 5 V und 0 V) angeordnet ist und eine Mehrzahl von parallel geschalteten Reihenschaltungen aus Widerständen 47 und Schaltern 48 enthält. Die Widerstände 47 können unterschiedlichen oder gleichen Wert aufweisen, wobei der jeweils vorhandene Widerstandswert dann durch den jeweils eingeschalteten Schalter 48 oder die Anzahl gleichzeitig eingeschalteter Schalter 48 definiert und hierdurch der jeweils gewünschte Diagnosestrom in die Stromspiegelschaltung 49 eingeprägt wird, die die Strombank 36 speist. Damit können unterschiedliche Sollströme zur Widerstands-, Spannungs- und Leckmessung zur erhöhten Meßgenauigkeit eingestellt werden. Der Strommeßwiderstand 13 ist in diesem Fall zwischen das Versorgungsspannungspotential für die Strombank 49 und den zugehörigen FET der Strombank 36 geschaltet, wobei der Strommeßausgang 11 an den Strombankanschluß des Widerstands 13 angeschlossen ist.

Bei der Diagnoseschaltung gemäß Fig. 2 ist die Konstantspannungsregelung für den Spannungsmeßanschluß 43 vorgesehen, so daß dieser Anschluß 43 an einen Eingang des Operationsverstärkers 39 angeschlossen ist. Dessen Ausgang ist mit dem Gate von FETs der Strombank 3 zur Arbeitspunkteinstellung verbunden, in die der Diagnosestrom über die Stromtreiberschaltung 46, die Strombank 36 und den zu testenden Verbraucher eingeprägt wird. Bei der Schaltung gemäß Fig. 2 ist der Konstantspannungswert, der dem Anschluß 43 aufgeprägt wird, über eine Pegeleinstellschaltung 51 variabel einstellbar, so daß die Konstantspannung für unterschiedliche Meßbereichseinstellung umschaltbar ist und/oder während einer Leckstrommessung in zwei oder mehr Schritten veränderbar ist, so daß auch Leckströme beispielsweise gegen ein festes Potential zuverlässig detektierbar sind. Die Pegeleinstellschaltung 51 enthält einen rückgekoppelten Operationsverstärker 52, dessen Verstärkungsfaktor über selektiv zu- und abschaltbare, zwischen seinen invertierenden Anschluß und Nullpotential geschaltete Widerstände 53 stufenweise veränderbar ist. Am nicht invertierenden Eingang des Operationsverstärkers 52 liegt eine feste Referenzspannung z.B. 1 V.

Zur Erzielung eines guten Abgleichs können bei der Fertigung mehrere Transistoren parallel vorgesehen sein, deren Gates mit dem Ausgang des Operationsverstärkers 39 verbunden sind und damit anfänglich einen Bestandteil der Stromspiegelschaltung 3 bilden. Zum Toleranzausgleich werden dann bei einer anfänglichen Kalibrierung die Feldeffekttransistoren derart selektiert, daß die Hochpegel- und Niederpegel-Stromspiegelschaltung gleiches Verhalten zeigen, d.h. bei Leckstromfreiheit das Potential an den Anschlüssen 8, 12, 15 tatsächlich exakt mittig zwischen den Anschlußpotentialen des Widerstandsspannungsteilers 14, 16 liegt. Die nicht benötigten Transistoren werden dann deaktiviert. Damit läßt sich eine bausteininterne Kalibrierung erreichen, so daß auf externe Abgleichmaßnahmen verzichtet werden kann.

In Fig. 3 ist eine zu diagnostizierende Schaltung dargestellt, die Zündpillen 55 enthält, die jeweils in Reihe zwischen zugehörige Zündtransistoren 56 und 57 geschaltet sind. Die Zündtransistoren 56, 57 sind mit ihren anderen Hauptanschlüssen mit einem Zündspannungsanschluß 58 bzw. Massepotential verbunden und werden durch ein nicht dargestelltes Steuergerät bei einem Unfall zur Zündung der jeweils selektierten Zündladung und damit zur Auslösung z.B. des Airbags durchgeschaltet. Die Anschlüsse der Zündpillen 55 sind jeweils mit Terminals von Anschlußports 60 (P1) und 61 (P2) verbunden, die als Schnittstelle zu den beispielsweise in einem ASIC integrierten, links von 60, 61 dargestellten Komponenten dienen. Weiterhin ist ein Multiplexer 62 vorgesehen, der für jeden Anschluß 9, 42, 43 und 44 eine Schalterbank mit einer Mehrzahl von Schaltern enthält, durch die die einzelnen Anschlüsse jeweils gleichzeitig mit einer gerade zu testenden Zündpille 55 verbunden werden. Durch den Multiplexer 62 können alle zu testenden Verbraucher 55 usw. selektiv nacheinander mittels ein- und derselben Meßschaltung (z.B. Fig. 1 oder Fig. 2) gemessen werden. Damit liegt ein für alle Verbraucher gleiches Meßprinzip vor, so daß das Meßkonzept jeweils gleich bleibt. Die Anzahl von Meßstellen ist beliebig erweiterbar, so daß beispielsweise nicht nur eine Widerstandsmessung oder Spannungsmessung durchführbar ist, sondern auch Schaltzustände externer Transistoren, Sensoren usw. gemessen werden können und eine Datenkommunikation möglich ist. Durch die zentrale Meßtechnik mit nur einer einzigen Meßschaltung und einem einheitlichen Meßprinzip, bei dem die jeweiligen Meßstellen separat angewählt werden können, ergeben sich die Vorteile eines einfachen Empfindlichkeitsabgleichs, gleicher Toleranzen für alle Messungen, und einer nur einmal benötigten Meßlogik, das heißt einer verhältnismäßig einfachen Schaltungsstruktur, wobei auch der Abgleich des die Messung durchführenden Bausteins, z.B. ASIC, nur einmalig erforderlich ist. Dieses Konzept eignet sich nicht nur für Messungen bei oder in einem ASIC, sondern kann auch auf beliebige Zündkreise oder sonstige Komponenten erweitert werden.

Mit der Erfindung ist es ferner möglich, auch gezielt zusätzliche Messungen durchzuführen, beispielsweise eine Spannungsmessung an internen Chipkomponenten, die an interne Meßanschlüsse 63 angeschlossen sind. Ferner ist es möglich, z.B. die Funktionsfähigkeit eines Schalters 64 zu überprüfen, der mit einem Anschluß an eine Zündpille 55 angeschlossen ist und mit seinem anderen Anschluß mit einem festen Potential, beispielsweise Massepotential, verbunden ist. Ein Schließen des Schalters 64 hat die gleichen Wirkungen wie ein in der angeschlossenen Zündpille 55 fließender Leckstrom, was über die Leckstromerfassungseinrichtung 12, 14 bis 16 erfaßbar ist. Anhand der Größe des gemessenen vermeintlichen Leckstroms und des eigentlich vom Schalter 64 bei korrekter Funktionsweise zu erwartenden Stromflusses läßt sich die Funktionsfähigkeit des Schalters 64 zuverlässig überprüfen. Hiermit können z.B. zur Gurtschloßerkennung verwendete Hall-Schalter auf ihre Funktionsfähigkeit getestet werden. Selbstverständlich ist es auch möglich, anders geartete elektrische Verbraucher zu testen, oder beispielsweise den Schalter 64 anstelle einer der Zündpillen 55 vorzusehen, das heißt beide Schalteranschlüsse jeweils mit einem zugehörigen Terminal der Anschlußports 60 und 61 zu verbinden, so daß neben einer Strommessung auch eine Spannungsmessung durchführbar ist.

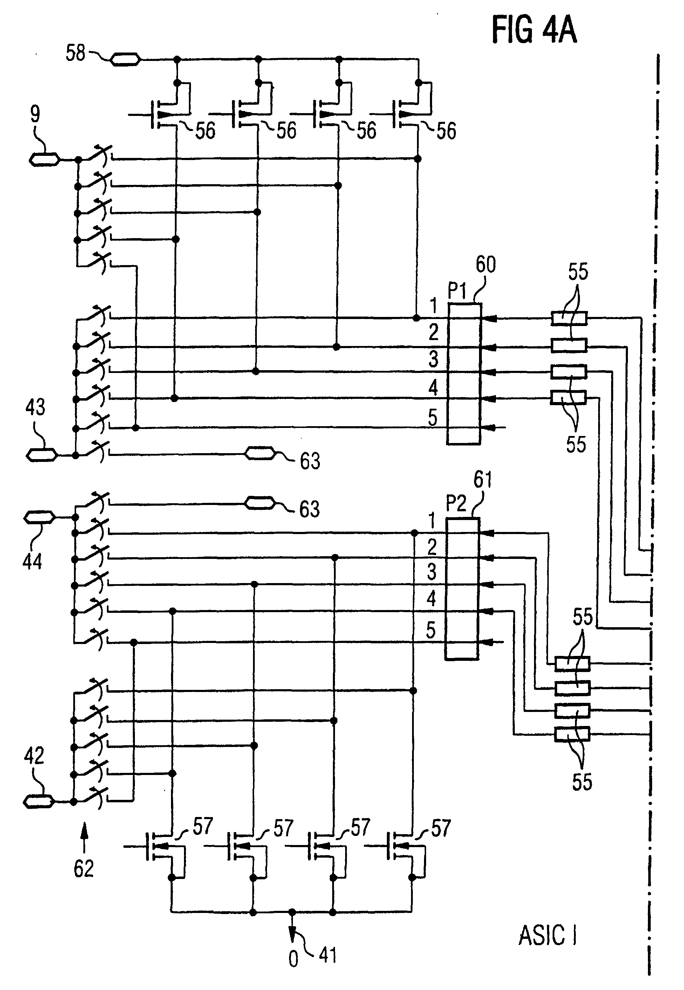

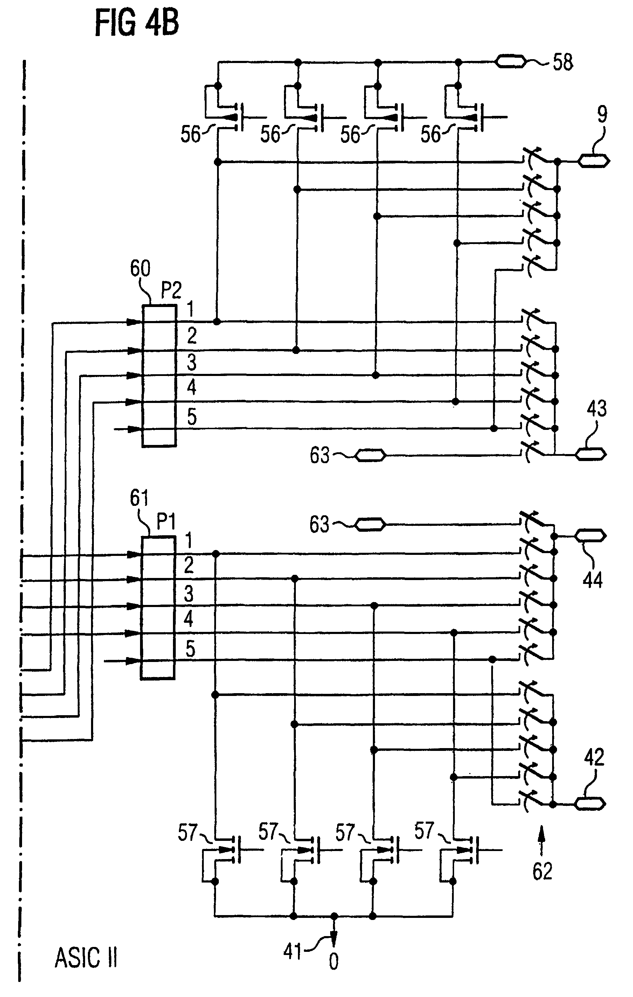

In Fig. 4 ist eine abgeänderte Ausführungsform gezeigt, bei der die Zündtransistorpaare jeder Zündpille (hier acht Zündpillen) 55 auf unterschiedliche Chips, insbesondere ASICs, aufgeteilt sind. Die links von den Zündpillen 55 und den linksseitigen Anschlußports 60, 61 in Fig. 4 dargestellten Komponenten sind auf einem Chip angeordnet, während die rechts von den Zündpillen 55 und den rechtsseitigen Anschlußports 60, 61 in Fig. 4 gezeigten Komponenten in einem anderen Chip angeordnet sind. Durch die gezeigte Anschlußtechnik sind die zu einer jeweiligen Zündpille gehörenden Transistoren auf zwei Chips verteilt, das heißt die Hochpegel-Zündtransistoren (high side) sind auf einem anderen Baustein als die Niederpegel-Zündtransistoren (low side) der jeweiligen Zündpillen angeordnet. Bei einer Störung, beispielsweise einem Durchbrennen eines der Chips wird zuverlässig ein Zünden der Zündpillen unterdrückt, da die weitere, zum Zünden der jeweiligen Zündpillen erforderliche Endstufe auf dem anderen Chip angeordnet ist. Die einzelnen, in Fig. 4 gezeigten Komponenten entsprechen den bereits anhand von Fig. 3 erläuterten, mit gleichen Bezugszeichen versehenen Komponenten, so daß auf die vorstehende Beschreibung verwiesen wird.

Wie ersichtlich, ist jeder Chip mit einem Multiplexer 62 ausgestattet. Die Meßanschlüsse 9, 42, 43, 44 sind mit der in Fig. 1 oder 2 gezeigten Meßschaltung jeweils unter gegenseitiger Entkopplung so verschaltet, daß der beispielsweise über den links oben dargestellten Meßanschluß 9 des linken Chips eingespeiste Diagnosestrom nach Durchfließen der selektierten Zündpille am Anschluß 42 des rechts dargestellten Chips abgegeben und zur Meßschaltung weitergeleitet wird. Derselbe Sachverhalt trifft sinngemäß auch für die anderen Anschlüsse zu. Die Steuerung der Multiplexer 62 ist vorzugsweise derart ausgelegt, daß bei Durchführung einer Messung die Schalter der oberen Hälfte des links dargestellten Multiplexers 62 synchron mit den Schaltern der unteren Hälfte des rechts dargestellten Multiplexers 62 zur Messung der vier oberen Meßpillen 55 betrieben werden, während hierbei die untere Hälfte des linken Multiplexers 62 und die obere Hälfte des rechts dargestellten Multiplexers 62 unbetätigt bleiben, das heißt die Schalter geöffnet gehalten werden. Bei Messung der vier unteren Zündpillen 55 sind die Verhältnisse umgekehrt, das heißt es wird die untere linke und obere rechte Hälfte der Multiplexer 62 betätigt, während die anderen Multiplexerabschnitte unbetätigt bleiben.

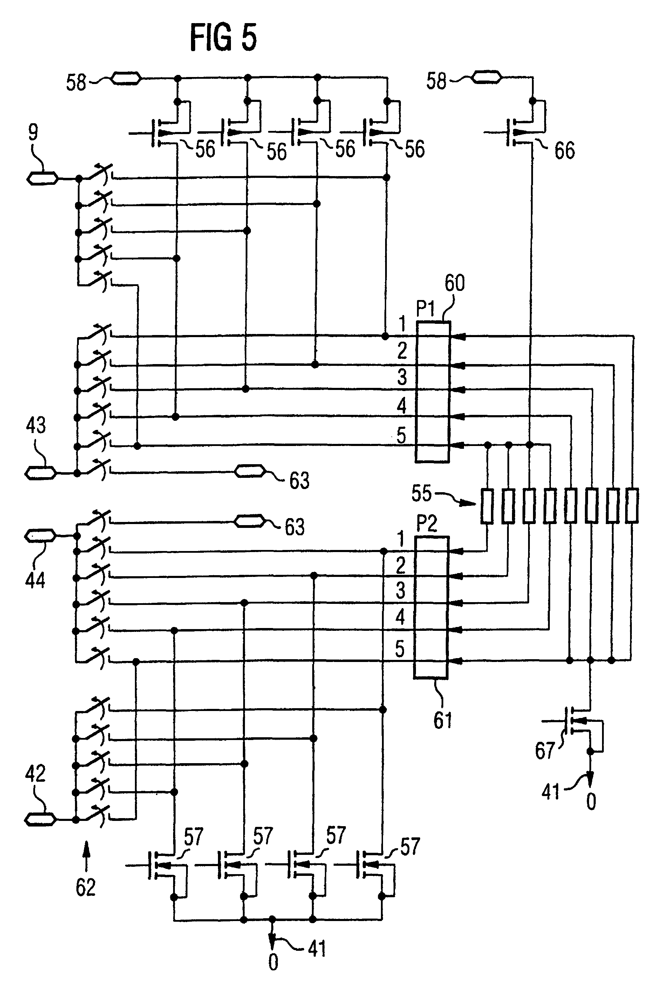

In Fig. 5 ist ein weiteres Ausführungbeispiel dargestellt, das eine Erhöhung der Anzahl von zu messenden und zu zündenden Zündpillen bei nur geringem Schaltungsmehraufwand ermöglicht. Die links von den Anschlußports 60, 61 in Fig. 5 dargestellten Komponenten entsprechen identisch den in Fig. 3 gezeigten und dort bereits beschriebenen Bestandteilen. Anstelle der vier in Fig. 3 gezeigten Zündpillen 55 sind beim Ausführungbeispiel gemäß Fig. 5 acht Zündpillen meßbar und ansteuerbar. Hierzu sind vier Zündpillen mit ihrem einen Anschluß zusammengeschaltet und über diesen gemeinsamen Anschluß einerseits an einen Anschluß des Anschlußports 60 und andererseits an einen gemeinsamen Zündtransistor 66 angeschlossen. Die anderen Anschlüsse dieser vier Zündpillen sind separat über den Anschlußport 61 an jeweils eigene Zündtransistoren 57 angeschlossen. Zur Zündung einer dieser Zündpillen werden der Zündtransistor 66 und gleichzeitig der zu dieser Zündpille zugeordnete Zündtransistor 57 durchgeschaltet.

EP 1 112 504 B1

Zur selektiven Diagnosemessung wird der Multiplexer 62 so geschaltet, daß der Diagnosestrom in den gemeisamen Zündpillenanschluß eingespeist wird, jedoch nur über die gerade selektierte Zündpille und den dieser zugeordneten Schalter der mit dem Anschluß 42 verbundenen Schalterbank des Multiplexers 62 zur Meßschaltung fließen kann.

Der Zündtransistor 66 kann als externer Zündtransistor ausgebildet sein, kann aber auch in dem gleichen Baustein wie die Zündtransistoren 56, 57 ausgebildet sein.

In gleichartiger Weise sind die Niederpegelanschlüsse der vier rechts dargestellten Zündpillen 55 zusammengefaßt und an einen gemeinsamen Anschluß des Anschlußports 61 sowie einen Zündtransistor 67 angeschlossen, über den sie bei einer Zündung an Nullpotential anschließbar sind. Die vier Hochpegelanschlüsse der vier rechts dargestellten Zündpillen 55 sind selektiv an jeweils eigene Anschlüsse des Anschlußports 60 angeschlossen, so daß eine selektive Diagnostizierbarkeit und Zündung auch dieser Zündpillen möglich ist. Der Zündtransistor 67 kann gleichfalls als externer Zündtransistor oder aber als Bestandteil des die Zündtransistoren 57 enthaltenden Chips ausgebildet sein. Zum selektiven Zünden von acht Zündpilien werden folglich lediglich zehn Leistungstransistoren benötigt, ohne daß die selektive Meßbarkeit und Auslösbarkeit verloren geht. Dies erlaubt einfachen Schaltungsaufbau. Zugleich kann die Meßschaltung (Fig. 1, Fig. 2) in diesem Fall zur Messung von acht Zündpillen eingesetzt werden, so daß eine sehr gute Ausnutzung erreicht ist, das heißt der gesamte Schaltungsaufwand verhältnismäßig gering ist.


**Patentansprüche**

1. Diagnoseschaltung zur Widerstands- und Leckstrommessung bei mindestens einer Zündpille (24) eines Kraftfahrzeug-Insassenschutzsystems, mit

    einer Aktivierungsschaltung (1, 3, 17 bis 20, 36) zur Stromspeisung des Verbrauchers bei einer Diagnosemessung,

    einer Widerstandsmeßschaltung (13, 30) zur Verbraucherwiderstandsermittlung, und

    einer vorzugsweise gleichzeitig mit der Widerstandsmeßschaltung betreibbaren Leckstrommeßschaltung (14 bis 16) zur Ermittlung eines bei der Diagnosemessung eventuell fließenden Leckstroms,

    **dadurch gekennzeichnet, daß** die Leckstrommeßschaltung eine Differenzmessung zwischen dem zu dem Verbraucher (24) gespeisten und dem von dem Verbraucher (24) zu einem Referenzpotential, insbesondere Masse, fließenden Strom ausführt, wobei mit den beiden Anschlüssen (23, 25) des Verbrauchers (24) Strombänke (1, 3 36) verbunden sind, an die die Leckstrommeßschaltung (14 bis 16) angeschlossen ist.

2. Diagnoseschaltung nach Anspruch 1, **dadurch gekennzeichnet, daß** die Leckstrommeßschaltung (14 bis 16) einen zwischen zwei Referenzpotentiale geschalteten Widerstandsspannungsteiler aufweist und die am Abgriff des Widerstandsspannungsteilers auftretende, den Leckstrom repräsentierende Spannung mißt.

3. Diagnoseschaltung nach Anspruch 2, **dadurch gekennzeichnet, daß** mit einer der Strombänke (36) ein Spannungsregler (39) verbunden ist, der die an dem dieser Strombank (36) zugeordneten Anschluß (25) des Verbrauchers (24) auftretende Spannung auf einen bestimmten, vorzugsweise einstellbaren Wert regelt.

4. Diagnoseschaltung nach Anspruch 1, **dadurch gekennzeichnet, daß** die Aktivierungsschaltung (1, 3, 17 bis 20, 36) eine bei der Diagnose zuschaltbare, vorzugsweise auf unterschiedlichen Stromwert einstellbare Stromquelle (18, 20) und mindestens eine Strombank (1, 3) enthält, die über getrennte Ausgangsanschlüsse (4 bis 9) mit der Stromquelle (18, 20), dem Verbraucher (24), der Widerstandsmeßschaltung (13, 30) und der Leckstrommeßschaltung (14 bis 16) verbunden ist und diese Komponenten mit gleich großen oder in festen Proportionalitätsbeziehungen stehenden Strömen speist.

5. Diagnoseschaltung nach Anspruch 4, **dadurch gekennzeichnet, daß** die Leckstrommessung mit einer geringeren Stromstärke als die Widerstandsmessung ausgeführt wird.

6. Diagnoseschaltung nach einem der vorhergehenden Ansprüche, **dadurch gekennzeichnet, daß** bei der Widerstandsmessung zwei Messungen mit unterschiedlich starken Strömen ausgeführt werden und die hierbei erzielten Meßergebnisse oder Zwischenergebnisse einer Differenzbildung, insbesondere zur Leckstromkompensation oder Offsetkompensation, unterzogen werden.

7. Diagnoseschaltung nach einem der vorhergehenden Ansprüche, **gekennzeichnet durch** einen vorzugsweise analog ausgebildeten Multiplexer, der mit den zu messenden Verbrauchern (24) jeweils in Reihe geschaltete Schalter (21, 27) aufweist.

8. Diagnoseschaltung nach Anspruch 7 in Verbindung mit Anspruch 3, **dadurch gekennzeichnet, daß** die Widerstandsmeßschaltung einen zur Spannungserfassung dienenden Spannungsdetektor (30) aufweist, der über selektiv durch den Multiplexer steuerbare Schalter (31, 34) mit den Anschlüssen (23, 25) der Verbraucher (24) verbindbar ist, und daß der Spannungsregler (39) mit einem Anschluß des Spannungsdetektors (30) verbunden ist.

9. Kfz-Insassenschutzsystem, mit mehreren Zündpillen, die mit einer Diagnoseschaltung nach einem der Ansprüche 1 bis 8 verbunden sind und jeweils zwischen zwei zur Zündung der Zündpillen einzuschaltenden Schaltelementen angeordnet sind, **dadurch gekennzeichnet, daß** die Schaltelemente auf zwei integrierte Schaltungschips aufgeteilt und die Zündpillen mit beiden Schaltungschips verbunden sind, derart, daß zur Zündung einer jeweiligen Zündpille ein Schaltelement in dem einen Schaltungschip und das zugehörige Schaltelement in dem anderen Schaltungschip gezündet werden muß.

10. Kfz-Insassenschutzsystem, mit mehreren Zündpillen, die mit einer Diagnoseschaltung nach einem der Ansprüche 1 bis 8 verbunden sind und jeweils zwischen zwei zur Zündung der Zündpillen einzuschaltenden Schaltelementen angeordnet sind, **dadurch gekennzeichnet, daß** mehrere Anschlüsse von Zündpillen zusammengeschaltet sind und durch ein gemeinsames Schaltelement angesteuert werden und die anderen Anschlüsse dieser Zündpille mit jeweils separaten Schaltelementen verbunden sind.

**Claims**

1. Diagnostic circuit for measuring the resistance and leakage current of at least one ignitor (24) of a motor vehicle occupant protection system, with:

   an activation circuit (1, 3, 17 to 20, 36) for feeding current to the load during a diagnostic measurement, a resistance measuring circuit (13, 30) for determining the load resistance, and, a leakage current measuring circuit (14 to 16) preferably capable of operating at the same time as the resistance measuring circuit for determining any leakage current which may be flowing during the diagnostic measurement,

   **characterised in that** the leakage current measuring circuit performs a differential measurement between the current fed to the load (24) and the current flowing from the load (24) to a reference potential, ground in particular, whereby current banks (1, 3, 36), to which the leakage current measuring circuit (14 to 16) is connected, are connected to the two terminals (23, 25) of the load (24).

2. Diagnostic circuit according to Claim 1, **characterised in that** the leakage current measuring circuit (14 to 16) has a resistance voltage divider connected between two reference potentials and measures the voltage occurring at the pick-off of the resistance voltage divider, representing the leakage current.

3. Diagnostic circuit according to Claim 2, **characterised in that** a voltage regulator (39) is connected to one of the current banks (36), which voltage regulator regulates the voltage occurring at the terminal (25) of the load (24) assigned to this current bank (36) to a certain value which can preferably be set.

4. Diagnostic circuit according to Claim 1, **characterised in that** the activation circuit (1, 3, 17 to 20, 36) contains a current source (18, 20) which can be switched in during the diagnostic process and can preferably be set to a variable current value, and at least one current bank (1, 3) which is connected by way of separate output terminals (4 to 9) to the current source (18, 20), the load (24), the resistance measuring circuit (13, 30) and the leakage current measuring circuit (14 to 16), and feeds these components with currents of equal size or in fixed proportionality relationships.

5. Diagnostic circuit according to Claim 4, **characterised in that** the leakage current measurement is performed with a lower current intensity than the resistance measurement.

6. Diagnostic circuit according to one of the preceding claims, **characterised in that** two measurements are performed with currents of differing intensities during the resistance measurement and that the measurement results or interim results obtained during this process are subjected to the formation of a difference, in particular for the purposes of leakage current compensation or offset compensation.

7. Diagnostic circuit according to one of the preceding claims, **characterised by** a multiplexer preferably employing an analogue construction, which has switches (21, 27) in each case connected in series with the loads (24) to be measured.

8. Diagnostic circuit according to Claim 7 in conjunction with Claim 3, **characterised in that** the resistance measuring circuit has a voltage detector (30) serving to detect the voltage, which can be connected by way of switches (31, 34), capable of being controlled selectively by the multiplexer, to the terminals (23, 25) of the loads (24), and that the voltage regulator (39) is connected to a terminal of the voltage detector (30).

9. Motor vehicle occupant protection system, with a plurality of ignitors which are connected to a diagnostic circuit according to one of Claims 1 to 8 and in each case are located between two switching elements to be activated for igniting the ignitors, **characterised in that** the switching elements are distributed on two integrated circuit chips and the ignitors are connected to both circuit chips such that in order to ignite a particular ignitor one switching element in the one circuit chip and the associated switching element in the other circuit chip need to be ignited.

10. Motor vehicle occupant protection system, with a plurality of ignitors which are in each case connected to a diagnostic circuit according to one of Claims 1 to 8 and are located between two switching elements to be activated for igniting the ignitors, **characterised in that** a plurality of terminals of ignitors are connected together and are controlled by a common switching element and the other terminals of this ignitor are each connected to separate switching elements.

**Revendications**

1. Circuit de diagnostic pour la mesure de la résistance et du courant de fuite pour au moins une pastille d'allumage (24) d'un système de protection des occupants d'un véhicule automobile, comportant :

   un circuit d'activation (1, 3,17 à 20, 36) pour l'alimentation en courant du consommateur lors d'une mesure de diagnostic,
   un circuit de mesure de résistance (13, 30) pour la détermination de la résistance d'un consommateur, et
   un circuit de mesure de courant de résistance (13, 30) pour la détermination de la résistance d'un consommateur, et
   un circuit de mesure de courant de fuite (14 à 16), de préférence susceptible de fonctionner simultanément au circuit de mesure de résistance, afin de déterminer un courant de fuite passant éventuellement lors de la mesure de diagnostic,

   **caractérisé en ce que** le circuit de mesure de courant de fuite effectue une mesure de différence entre le courant injecté dans le consommateur (24) et le courant passant du consommateur (24) à un potentiel de référence, en particulier la masse, des bancs de courant (1, 3, 36), auxquels est raccordé le circuit de mesure de courant de fuite (14 à 16), étant reliés aux deux bornes (23, 25) du consommateur (24).

2. Circuit de diagnostic selon la revendication 1, **caractérisé en ce que** le circuit de mesure de courant de fuite (14 à 16) présente un diviseur de tension à résistances branché entre deux potentiels de référence et mesure la tension, représentant le courant de fuite, produite sur la prise du diviseur de tension à résistances.

3. Circuit de diagnostic selon la revendication 2, **caractérisé en ce que** l'un des bancs de courant (36) est relié à un régulateur de tension (39) qui règle à une valeur déterminée, de préférence réglable, la tension régnant sur la borne (25), associée à ce banc de courant (36), du consommateur (24).

4. Circuit de diagnostic selon la revendication 1, **caractérisé en ce que** le circuit d'activation (1, 3, 17 à 20, 36) comporte une source de courant (18, 20) pouvant, lors du diagnostic, être mis en circuit et étant de préférence réglable à une valeur de courant particulière, et au moins un banc de courant (1, 3) qui est relié, par l'intermédiaire de bornes de sortie (4 à 9) séparées, à la source de courant (18, 20), au consommateur (24), au circuit de mesure de résistance (13, 30) et au circuit de mesure de courant de fuite (14 à 16), et qui alimente ces composants avec des courants de même valeur ou bien de valeurs ayant des relations de proportionnalité fixes.

5. Circuit de diagnostic selon la revendication 4, **caractérisé en ce que** la mesure de courant de fuite est effectuée avec une intensité de courant plus faible que la mesure de résistance.

**6.** Circuit de diagnostic selon l'une des revendications précédentes, **caractérisé en ce que** lors de la mesure de résistance sont effectuées deux mesures avec des courants d'intensités différentes et les résultats de mesure ou les résultats intermédiaires alors obtenus sont soumis à une formation de différence, en particulier dans le but d'une compensation de courant de fuite ou d'une compensation de décalage (offset).

**7.** Circuit de diagnostic selon l'une des revendications précédentes, **caractérisé par** un multiplexeur, de préférence de réalisation analogique, présentant des interrupteurs (21, 27) respectivement branchés en série avec les consommateurs (24) à mesurer.

**8.** Circuit de diagnostic selon la revendication 7, en liaison avec la revendication 3, **caractérisé en ce que** le circuit de mesure de résistance présente un détecteur de tension (30) servant à la détection de la tension, qui est susceptible d'être relié, par l'intermédiaire d'interrupteurs (31, 34) pouvant être commandés sélectivement par le multiplexeur, aux bornes (23, 25) des consommateurs (24), et **en ce que** le régulateur de tension (39) est relié à une borne du détecteur de tension (30).

**9.** Système de protection des occupants d'un véhicule automobile comportant plusieurs pastilles d'allumage, reliées à un circuit de diagnostic selon l'une des revendications 1 à 8 et disposées chacune entre deux éléments de commutation devant être commutés pour provoquer l'allumage des pastilles d'allumage, **caractérisé en ce que** les éléments de commutation sont répartis sur deux puces de circuit intégré et les pastilles d'allumage sont reliées aux deux puces de circuit, de manière que, pour obtenir l'allumage d'une pastille d'allumage donnée, un élément de commutation placé dans l'une des puces de circuit doive être actionné et l'élément de commutation correspondant placé dans l'autre puce de circuit, doive être actionné.

**10.** Système de protection des occupants d'un véhicule automobile, comportant une pluralité de pastilles d'allumage reliées à un circuit de diagnostic selon l'une des revendications 1 à 8 et disposées chacune entre deux éléments de commutation devant être commutés pour produire l'allumage des pastilles d'allumage, **caractérisé en ce que** plusieurs bornes de pastille d'allumage sont branchées ensemble et commandées par un élément de commutation commun et les autres bornes de cette pastille d'allumage étant reliées respectivement à des éléments de commutation séparés.

# FIG 1

# FIG 2

# FIG 3

# FIG 4A

ASIC I

# FIG 4B

ASIC II

# FIG 5